# EUROPEAN PATENT APPLICATION

(11) **EP 1 400 613 A2**
(43) Date of publication of application: **24.03.2004**
(21) Application number: 03255696.1
(22) Date of filing: 11.09.2003
(51) Int. Cl.: C25D 5/34

(54) **Tin plating method**

(30) Priority: 13.09.2002 US 410637 P
(71) Applicant: Shipley Co. L.L.C., Marlborough, MA 01752 (US)
(72) Inventor: Zhang, Wan, 6006 Luzern (CH); Heber, Jochen, 75305 Neuenbuerg (DE); Egli, André, 8805 Richterswill (CH); Schwager, Felix, 6045 Meggen (CH)
(74) Representative: Kent, Venetia Katherine

(57) **Abstract**

Methods of electrodepositing layers of tin or tin-alloys on a substrate are provided. The methods involve electrolytically treating a substrate with a solution comprising a phosphoric acid and a carboxylic acid, and electrodepositing a layer of tin or tin-alloy on a surface of the treated substrate. The methods can provide tin or tin-alloy layers having a reduced tendency to form whiskers.

## Description

### Cross-Reference to Related Applications

The present application claims the benefit under 35 U.S.C. § 119(c) of U.S. Provisional Application No. 60/410,637, filed September 13, 2002, the entire content of which is herein incorporated by reference.

### Background of the Invention

In general, the present invention relates to the field of tin and tin-alloy plating. In particular, the present invention relates to methods of electrodepositing a layer of tin or tin-alloy on a substrate that can provide reduced whisker formation in the deposited film.

Tin and tin-alloy layers are typically used in the electronics industry to provide good solderability of components. For example, tin and tin-alloy layers may be deposited on a copper lead frame to provide a soldcrable finish, Unfortunately, tin and tin-alloy layers, particularly electrodeposited tin and tin-alloy layers, are subject to spontaneous whisker formation. "Whiskers" arc hair-like single crystals that grow from the surface of the tin layer. Tin whiskers typically range in diameter from a few microns to about twenty microns, and can reach lengths of several millimeters. Such whiskers can create shorts and introduce noise into electronic circuitry, thus creating a reliability problem in electronic devices.

Conventionally, the use of tin-lead alloys has been provided as a solution to the tin whisker problem. Generally, it is agreed that such alloys arc significantly less prone to whisker formation than tin itself. However, the current worldwide activities to ban the use of lead have caused the tin whisker problem to resurface as lead-free tin deposits are increasingly used.

It is believed that tin whiskers form as a result of stresses in the tin or tin-alloy layer, although bulk diffusion of tin is also believed to be involved. However, the precise growth mechanism of tin whiskers is not fully understood. A number of stress-causing factors have been postulated, including lattice stresses due to the presence of impurity atoms in the tin layer, residual stresses due to tin plating conditions, stresses due to mechanical loading or working of the tin layer, stresses due to interaction with adjacent layers, such as intermetallic compound formation, differences in thermal expansion and the like, among others. See, for example, Ewell et al., *Tin Whiskers and Passive Components: A Review of the Concerns,* 18^{th} Capacitor and Resistor Technology Symposium, pp 222-228, March, 1998.

The primary focus regarding the reduction of tin whiskering in tin and tin-alloy films has been on the conditions of the tin or tin-alloy deposition process. For example, one approach to reducing tin whisker formation has been to use relatively thick tin layers, for example, layers of about 10 microns thickness. However, such thick layers are not always practical or they may be too thick for certain applications, such as current microelectronic applications. A further approach to whisker formation reduction is described in U.S. Patent No. 5,750,017 (Zhang), which discloses a method of electrodepositing tin or tin-alloy onto a metal substrate using pulse plating conditions. Such plating method provides a tin layer typically having a thickness of 3 to 6 microns, wherein the grain size of the tin is from 2 to 8 microns. Although such grain size is postulated by Zhang to reduce tin whisker formation, such tin deposits still suffer from tin whisker growth.

K.N. Tu, Materials Chemistry and Physics 46 (1996) 217-223, and K.N. Tu, Physical Review B, Volume 49 (3) (1994), 2030-2034, demonstrate that the very beginning of whisker growth correlates with the formation of intermetallic compounds (IMC), It is not, however, only the pure abundance of the IMC that initiates whisker growth. At least as important is the morphology and in particular the uniformity of the IMC layer between the substrate and the tin electrodeposit. According to Lee and Lee, *Spontaneous Growth mechanism of Tin Whiskers,* Acta Mater., vol. 46, no. 10, pp 3701-3714, 1998, an inhomogeneous build-up of the IMC layer results in so-called bi-axial compressive stress, which then is released in the form of whisker growth. From this, that document concludes that a smooth and uniform IMC layer provides a means to significantly reduce whisker growth.

There is a need in the art for methods of providing tin and tin-alloy layers having reduced tin whisker formation.

### Summary of the Invention

It has been surprisingly and unexpectedly discovered that tin whisker formation can be significantly reduced by subjecting the substrate to be plated to a process prior to the plating step, In accordance with a first aspect of thc invention, a method of electrodepositing a layer of tin or tin-alloy on a substrate is provided. The method involves electrolytically treating a substrate with a solution containing a phosphoric acid and a carboxylic acid, and electrodepositing a layer of tin or tin-alloy on a surface of the treated substrate.

In accordance with a further aspect of the invention, a method of electrodepositing a layer of tin or tin-alloy on a substrate is provided. The method involves electrolytically treating a substrate with a solution containing from 50 to 80% by volume of a carboxylic acid, and electrodepositing a layer of tin or tin-alloy on a surface of the treated substrate.

### Brief Description of the Drawings

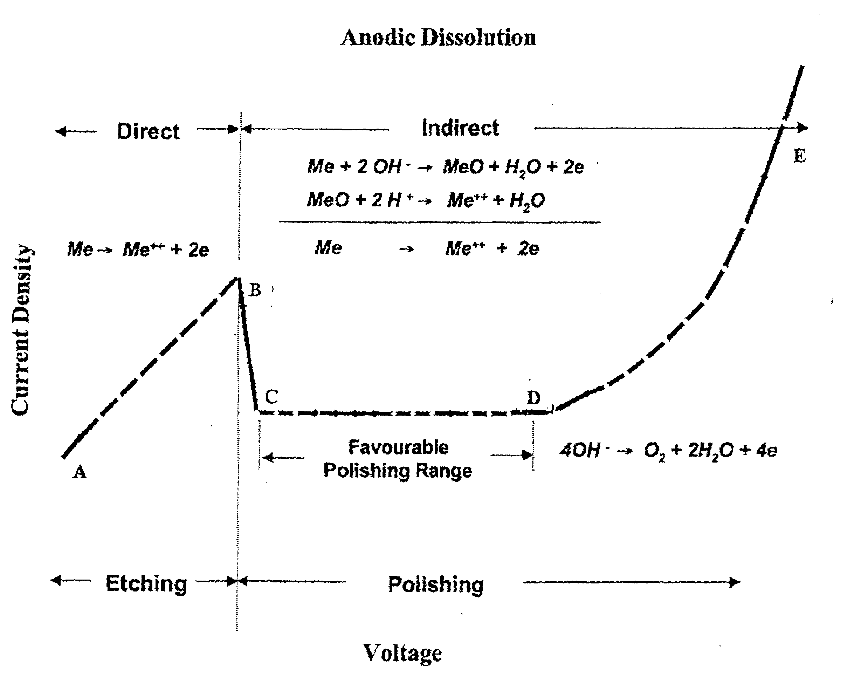

Fig. 1 is a graph of current density versus voltage for an exemplary plating preconditioning solution in accordance with the invention.

### Detailed Description of the Invention

As used throughout this specification, the following abbreviations shall have the following meanings, unless the context clearly indicates otherwise: °C refers to degrees Centigrade; g refers to grams; L refers to liters; mL refers to milliliters; A refers to amperes; dm refers to decimeters; and µm refers to microns or micrometers. All amounts are percent by volume, unless otherwise noted. All numerical ranges are inclusive and combinable in any order, except where it is obvious that such numerical ranges are constrained to add up to 100%.

Accordingly, the present invention provides a method of electrodepositing a layer of tin or tin-alloy on a substrate. The substrate is typically an electronic device substrate, for example, a printed wiring board substrate, a lead frame, a semiconductor package, a chip capacitor, a chip resistor, a connector, a contact, or the like. Typical materials of construction for the substrate include, but are not limited to, copper, copper-alloys such as brass, nickel, nickel-alloys, cobalt, cobalt-alloys, and the like. It is preferred that the substrate is a copper-containing substrate, such as a copper or copper-alloy layer. Copper-alloys such as C7025, C194, K75, and C151 are particularly suitable. These copper-alloys are, however, particularly prone to whisker formation. Another problem with certain copper-alloys, for example, C7025, is smut formation.

Prior to the tin or tin-alloy electroplating process, the substrate is electrolytically treated in order to precondition the surface for plating. The preconditioning step is beneficially carried out so as to polish and smooth the substrate surface. It is believed that such a surface allows for uniform diffusion of the later deposited tin into the substrate to form a uniform layer of the intermetallic compound. With surface polishing, peaks in a non-uniform surface are preferentially removed relative to lower areas of the substrate surface. This is in contrast to surface preconditioning in which the surface of the substrate is not polished, but is etched. Etching refers to a non-preferential removal of material form the substrate surface. Surface etching provides a roughened substrate surface, resulting in non-uniform diffusion of the tin into the substrate and creating localized areas of stress in the tin or tin-alloy layer, where tin whisker formation can be induced.

In accordance with one aspect of the invention, the preconditioning treatment involves electrolytically treating the substrate with a solution that contains a phosphoric acid and a carboxylic acid. In accordance with a further aspect of the invention, the preconditioning solution contains from 50 to 80% by volume of a carboxylic acid. Typically, the pH of such baths is from about 0 to about 3, and preferably about 1.

The phosphoric acid can be, for example, orthophosphoric acid or pyrophosphoric acid. Of these, orthophosphoric acid is preferred and is typically present in the solution an amount of from 20 to 80 % by volume, preferably in an amount of from 30 to 40 % by volume, based on the solution.

The carboxylic acid can be substituted, for example, hydroxycarboxylic acids, or unsubstituted, and can be a polycarboxylic acid. Suitable carboxylic acids include, for example, oxalic acid, malonic acid, methylmalonic acid, dimethylmalonic acid, maleic acid, malic acid, citramalic acid, tartaric acid, phthalic acid, citric acid, glutaric acid, glycolic acid, lactic acid, pyruvic acid, oxalacetic acid, α-ketoglutaric acid, salicylic acid, acetoacetic acid, and combinations thereof. Of these, preferred carboxylic acids include malic acid, tartaric acid, citric acid, lactic acid, and other aldonic and aldaric acids, and combinations thereof. The carboxylic acid is typically present in the pretreatment solution in an amount of from 10 to 600 g/L when used in combination with a phosphoric acid, and from 400 to 800 g/L when used in the absence of a phosphoric acid.

Optionally, the pretreatment solution can include an alkali metal hydroxide, such as sodium hydroxide or potassium hydroxide. The alkali metal hydroxide can be used for pH adjustment, if desired. The alkali metal hydroxide is typically present in the pretreatment solution in an amount of from 0 to 300 g/L based on the solution.

The solvent used in the preconditioning solution is typically deionized water. Optionally, an organic solvent can be used in addition to the deionized water. It has been found that the current density during the pretreatment process can be adjusted by use of an organic solvent, thereby allowing for additional control of the process to selectively achieve a desired surface polishing voltage as shown in FIG. 1. Suitable organic solvents include, for example, ethylene glycol, propylene glycol, glycerin, and low molecular weight alcohols such as ethanol and isopropyl alcohol. The organic solvent is typically present in the solution in an amount from 0 to 40 % by volume.

One or more additives can optionally be used in the preconditioning solution. Such additives include, for example, wetting agents and other surface-active agents known to those skilled in the art.

The substrate is introduced into a pretreatment tank containing the pretreatment solution. Typically, the preconditioning solution is at a temperature of from about 15° to about 40°C, preferably from about 20° to 30°C, during processing. The substrate can be anodically and/or cathodically biased during the pretreatment process. Preferably, the substrate is anodically biased, The choice of the particular electrolytic treatment will depend, for example, upon the particular substrate and the type of layer to be deposited.

The voltage during the preconditioning step is preferably selected so as to favor substrate polishing over etching. In this regard, Fig. 1 is a typical graph of current density versus voltage for a plating preconditioning solution. The voltage is that between the anode (the substrate being treated) and a probe electrode which contacts the solution. As can be seen, the current density increases with an increase in voltage between points A and B. In this A-B region, the metal (Me) is converted directly to its ionic form (Me⁺⁺) and results in etching of the substrate surface. With a further increase in voltage, a sharp decrease in current density occurs between points B and C, marking the transition region between direct and indirect conversion of the metal to its ionic form. Indirect conversion is responsible for substrate polishing, with the metal being converted to metal oxide (MeO) before being converted to its ionic form. The region between points C and D marks the most favorable polishing range, in which the current density remains constant with increased voltage. A minimum applied voltage is thus desired for polishing of the substrate. Between points D and E, the current density increases with increased voltage. While the voltage effective to polish the substrate will depend on the particular substrate being treated and the pretreatment solution, the voltage typically ranges from 3 to 20V, preferably from 4 to 8V. This typically results in a current density of from about 10 to 50 A/dm², depending, for example, on solution composition, tank geometry, and agitation.

The pretreatment process is typically conducted until a smooth, highly polished and reflective substrate surface is obtained. The process time is typically from 15 to 90 seconds, preferably from 15 to 30 seconds.

In addition to its beneficial effect on whisker formation, the pretreatment process in accordance with the invention can effectively prevent the formation of smut, which frequently occurs on the surface of copper-alloy substrates.

Following the pretreatment process, the substrate is rinsed with deionized water to ensure removal of the pretreatment solution from the substrate. Preferably, the water rinse is a high pressure rinse. Optionally, the water rinse can be followed by a predip process in which the substrate is contacted with a solution of an acid. Preferably, the acid will be the same as used in the electrolyte for the plating process to follow. The predip is typically conducted at 25°C for a period of from 10 to 40 seconds.

The tin or tin-alloy is next electrodeposited. "Tin-alloy" refers to any metal containing tin and one or more other alloying elements, and thus includes, for example, binary alloys, ternary alloys and the like. Suitable alloying elements include, but are not limited to, bismuth, copper, silver, lead, antimony and zinc, and preferably bismuth, copper and silver. A particularly suitable tin-alloy is tin-copper. Such tin-copper alloys may contain, for example, from 0.5 to 10% copper, the balance being tin. Such tin-copper alloys may optionally contain small amounts of other alloying elements. The concentrations of the one or more alloying elements may vary over a wide range. The range of such alloying elements is well within the ability of one skilled in the art. The thickness of the tin or tin-alloy layers may vary across a wide range, depending upon the particular application. For example, when a tin or tin-alloy layer is deposited on a lead frame, it is typically from 1 to 10 microns thick.

The tin or tin-alloy layer may be deposited by a variety of means. Preferably, the tin or tin-alloy is deposited electrolytically in a high speed electroplating system. Such systems are known to persons skilled in the art. The plating solution is introduced into the system such that it substantially fills the plating cell, continuously overflows into an overflow reservoir, and is continuously returned to the cell. The substrates pass through the electroplating solution in the cell.. Such electrolytic deposition may be, for example, by direct current ("DC") or pulse plating, including pulse periodic reverse plating. The choice of the deposition technique will depend, for example, upon the particular substrate and the layer to be deposited. Typically, the tin or tin-alloy plating bath is at a temperature of from about 20° to about 60° C, preferably from about 35° to 45°C. Typically, the current density for the tin or tin-alloy electroplating is from 1 to 50 amps/dm², preferably from 5 to 30 A/dm².

Suitable electrolytic tin or tin-alloy plating baths may be acidic or alkaline. An exemplary acidic tin electroplating bath contains one or more solution soluble tin compounds, one or more acidic electrolytes, and optionally one or more additives. Suitable tin compounds include, but are not limited to salts, such as tin halides, tin sulfates, tin alkane sulfonate such as tin methane sulfonate, tin aryl sulfonate such as tin phenyl sulfonate, tin phenol sulfonate and tin toluene sulfonate, tin alkanol sulfonate, and the like. It is preferred that the tin compound is tin sulfate, tin chloride, tin alkane sulfonate or tin aryl sulfonate, and more preferably tin sulfate or tin methane sulfonate. The amount of tin compound in these electrolyte compositions is typically an amount that provides a tin content in the range of 5 to 150 g/L, preferably 30 to 80 g/L, and more preferably 40 to 60g/l. Mixtures of tin compounds may optionally be used in an amount as described above.

Any acidic electrolyte that is solution soluble, is suitable for producing a stable tin electrolyte, and does not otherwise adversely affect the electrolyte composition may be used. Suitable acidic electrolytes include, but arc not limited to, alkane sulfonic acids, such as methane sulfonic acid, ethane sulfonic acid and propane sulfonic acid, aryl sulfonic acids, such as phenyl sulfonic acid, phenol sulfonic acid and toluene sulfonic acid, sulfuric acid, sulfamic acid, hydrochloric acid, hydrobromic acid, fluoroboric acid and mixtures thereof. Typically, the amount of acidic electrolyte is in the range of from 10 to 400 g/L, preferably from 50 to 400 g/L, and more preferably from 150 to 300 g/L. It is preferred that when the tin compound is a halide, the acidic electrolyte is the corresponding acid. For example, when tin chloride is used in the present invention, it is preferred that the acidic electrolyte is hydrochloric acid.

In tin-alloy plating baths, one or more alloying metal compound is used in addition to tin. Suitable other metals include, but are not limited to, lead, nickel, copper, bismuth, zinc, silver, antimony, indium and the like. A particularly suitable tin-alloy is tin-copper. The other metal compounds useful in the present invention are any which provide the metal to the electrolyte composition in a soluble form. Thus, the metal compounds include, but are not limited to, salts, such as metal halides, metal sulfates, metal alkane sulfonates, such as metal methane sulfonate, metal aryl sulfonates, such as metal phenyl sulfonate and metal toluene sulfonate, metal alkanol sulfonates, and the like. The choice of the other metal compound(s) and the amount of such other metal compound(s) present in the electrolyte composition depends, for example, upon the tin-alloy to be deposited, and is well known to those skilled in the art.

It will be appreciated by those skilled in the art that one or more other additives may be used in the tin or tin-alloy electroplating baths, such as reducing agents, grain refiners such as hydroxy aromatic compounds and other wetting agents, brightening agents, antioxidants, and the like. Mixtures of additives may also be used in the present invention. Such additives arc useful, for example, in enhancing the efficiency and/or quality of thc plating.

Reducing agents may be added to the tin and tin-alloy electrolyte compositions to assist in keeping the tin in a soluble, divalent state. Suitable reducing agents include, but are not limited to, hydroquinone and hydroxylated aromatic compounds, such as resorcinol, catechol, and the like. Suitable reducing agents are those disclosed, for example, in U.S. Patent No. 4,871,429. The amount of such reducing agent is typically from 0.1 g/L to 5 g/L.

Bright deposits may be obtained by adding brighteners to the tin and tin-alloy electrolyte compositions. Such brighteners are well known to those skilled in the art. Suitable brighteners include, but are not limited to, aromatic aldehydes such as naphthaldehyde benzaldehyde, allylbenzaldehyde, methoxybenzaldehyde and chlorobenzaldehyde, derivatives of aromatic aldehydes, such as benzyl acetone and benzylidine acetone, aliphatic aldehydes, such as acetaldehyde or glutaraldehyde, and acids such as acrylic acid, methacrylic acid and picolinic acid. Typically, brighteners are used at an amount of 0.1 to 3 g/L, and preferably 0.5 to 2 g/L.

Suitable non-ionic surfactants or wetting agents include, but are not limited to, relatively low molecular volume ethylene oxide ("EO") and/or propylene oxide ("PO") derivatives of aliphatic alcohols containing one or more alkyl group or ethylene oxide- and/or propylene oxide-derivatives of aromatic alcohols. The aliphatic alcohols maybe saturated or unsaturated. Such aliphatic and aromatic alcohols may be further substituted, for example, with sulfate or sulfonate groups. Suitable wetting agents include, but are not limited to, ethoxylated polystyrenated phenol containing 12 moles of EO, ethoxylated butanol containing 5 moles of EO, ethoxylated butanol containing 16 moles of EO, ethoxylated butanol containing 8 moles of EO, ethoxylated octanol containing 12 moles of EO, ethoxylated octylphenol containing 12 moles of EO, ethoxylated/propoxylated butanol, ethylene oxide/propylene oxide block copolymers, ethoxylated beta-naphthol containing 8 or 13 moles of EO, ethoxylated beta-naphthol containing 10 moles of EO, ethoxylated bisphenol A containing 10 moles of EO, ethoxylated bisphenol A containing 13 moles of EO, sulfated ethoxylated bisphenol A containing 30 moles of EO, and ethoxylated bisphenol A containing 8 moles of EO. Typically, such non-ionic surfactants or wetting agents are added in an amount of 0.1 to 50 g/L, and preferably 0.5 to 10 g/L.

It will be appreciated by those skilled in the art that hydroxy aromatic compounds or other wetting agents may be added to these electrolyte compositions to provide further grain refinement. Such grain refiners may be added to further improve deposit appearance and operating current density range. Suitable other wetting agents include, but arc not limited to, alkoxylates, such as the polyethoxylated amines JEFFAMINE T-403 or TRITON RW, sulfated alkyl ethoxylates, such as TRITON QS-15, and gelatin or gelatin derivatives. The amounts of such grain refiners useful are well known to those skilled in the art and typically from 0.01 to 20 mL/L, preferably from 0.5 to 8 mL/L, and more preferably from 1 to 5 mL/L.

Optionally, an antioxidant compound can be employed in the electrolyte composition to minimize or prevent stannous tin oxidation from occurring, for example, from the divalent to tetravalent state. Suitable antioxidant compounds are known to those skilled in the art. Typically, such antioxidant compounds are present in the electrolyte composition in an amount of from 0 to 2 g/l.

The optional additives, if any, that are added to the electrolyte compositions will depend upon the results and types of deposits desired.

The tin layer of the present invention can optionally be deposited on one or more underlayer, Suitable undcrlayer materials include, but are not limited to, nickel, cobalt and alloys thereof. By "nickel-alloy" is meant any metal containing nickel and one or more different alloying elements, and thus includes binary alloys, ternary alloys and the like. By "cobalt-alloy" is meant any metal containing cobalt and one or more different alloying elements, and thus includes binary alloys, ternary alloys and the like. Suitable alloying elements include, but are not limited to, tungsten, nickel, cobalt, phosphorus, and the like. The amount of nickel in a nickel-alloy and cobalt in a cobalt-alloy varies over a wide range and is well within the ability of one skilled in the art. Particularly suitable underlayers include nickel, cobalt, nickel-cobalt, nickel-phosphorus and nickel-tungsten. Particularly suitable nickel-phosphorus-alloys include those having from 2 to 13 % phosphorus.

As a result of the present invention, whisker formation in tin and tin-alloy layers can be reduced or even eliminated.

The following examples illustrate methods of reducing tin whisker formation in accordance with the invention, but are not intended to limit the scope of the invention in any aspect.

### Example 1

A plating pretreatment solution is prepared by combining 40 % by volume orthophosphoric acid (85%), 150 g/l lactic acid, 40 g/L sodium hydroxide, and balanced with deionized water to 1 L. The temperature of the solution is 25°C and the pH is 1. C194 copper-alloy lead frames are introduced into the solution and are anodically biased at above 3V for 30 seconds, resulting in a current density of 20 to 30 A/dm². The treated lead frames are rinsed with deionized water and visually inspected for smut formation.

The lead frames are dipped in a solution of 15 % by volume methane sulfonic acid at 25°C for 30 seconds. A plating bath is prepared by combining 50 g/L tin as tin(II) methane sulfonate, 160 g/L free methane sulfonic acid, 25 g/L ethoxylated beta-naphthol containing 8 moles EO, and 5 g/L ethoxylated bisphcnol A. The lead frames are electroplated in the bath at a temperature of 40°C and a current density of 20 A/dm² using direct current plating in a high speed electroplating system. The plating solution is introduced into the system such that it substantially fills the plating cell, continuously overflows into an overflow reservoir, and is continuously returned to the cell. The substrates pass through the electroplating solution in the cell.

One lead frame is analyzed for the presence of whiskers by SEM after plating. The remaining plated lead frames are stored under controlled conditions in a test chamber at 52° C and 98% relative humidity. The samples are removed from the test chamber at one month intervals and analyzed by SEM for the presence of whiskers.

### Example 2

The procedures of Example 1 are repeated, except C7025 copper-alloy lead frames and a pretreatment voltage of above 4V are used.

### Example 3

The procedures of Example 1 are repeated, except K75 copper-alloy lead frames are used, and the pretreatment solution is prepared by combining 30 % by volume orthophosphoric acid (85%), 360 g/l lactic acid, and 20 % by volume propylene glycol, balanced with deionized water to 1 L. The lead frames are anodically biased at above 4V for 30 seconds, resulting in a current density of 5 to 10 A/dm².

### Example 4

The procedures of Example 1 are repeated, except C194 copper-alloy lead frames are used, and the pretreatment solution is prepared by combining 40 % by volume orthophosphoric acid (85%), 100 g/l malic acid, and 10 % by volume propylene glycol, balanced with deionized water to 1 L. The lead frames are anodically blased at above 4V for 30 seconds, resulting in a current density of 15 to 20 A/dm².

### Example 5

The procedures of Example 1 arc repeated, except the lactic acid is replaced with citric acid.

### Example 6

The procedures of Example 1 are repeated, except the lactic acid is replaced with malic acid.

### Example 7

The procedures of Example 1 are repeated, except the plating pretreatment solution is prepared by combining 400 g/L lactic acid, 40 g/L sodium hydroxide, and the balance deionized water.

It is expected that inspection of the lead frames after pretreatment would show smooth, highly polished and reflective surfaces that are smut-free. It is further expected that the results from the SEM analyses would show that the electroplated layers are substantially whisker free.

While the invention has been described in detail with reference to specific embodiments thereof, it will be apparent to one skilled in the art that various changes and modifications can be made, and equivalents employed, without departing from the scope of the claims,

## Claims

1. A method of electrodepositing a layer of tin or tin-alloy on a substrate, comprising:
electrolytically treating a substrate with a solution comprising a phosphoric acid and a carboxylic acid; and
electrodepositing a layer of tin or tin-alloy on a surface of the treated substrate.

2. The method according to claim 1, wherein the substrate is constructed of a copper-containing metal or metal-alloy.

3. The method according to claim 1 or 2, wherein the electronic device substrate is a printed wiring board substrate, a lead frame, a semiconductor package, a chip capacitor, a chip resistor, a connector, or a contact.

4. The method according to any of claims 1-3, wherein the phosphoric acid is orthophosphoric acid present in the solution an amount of from 20 to 80 % by volume.

5. The method according to any of claims claim 1-4, wherein the carboxylic acid is malic acid, tartaric acid, citric acid, lactic acid, or a combination thereof.

6. The method according to any of claims 1-4, wherein the carboxylic acid is a hydroxycarboxylic acid.

7. The method according to any of claims 1-6, wherein the solution further comprises an alkali metal hydroxide.

8. The method according to any of claims 1-7, wherein the solution further comprises an organic solvent.

9. The method according to any of claims 1-8, wherein the step of electrolytically treating is conducted at a voltage effective to polish the surface of the substrate.

10. A method of electrodepositing a layer of tin or tin-alloy on a substrate, comprising:
electrolytically treating a substrate with a solution comprising from 50 to 80% by volume of a carboxylic acid; and
electrodepositing a layer of tin or tin-alloy on a surface of the treated substrate.
